# EUROPEAN PATENT APPLICATION

(11) **EP 4 597 118 A1**
(43) Date of publication of application: **06.08.2025**
(21) Application number: 24219412.4
(22) Date of filing: 12.12.2024
(51) Int. Cl.: G01P 3/488, G01P 3/489, G01D 5/14

(54) **SENSOR FOR DETECTING SPEED OF A TARGET COMPRISING ONE OR MORE OF MAGNETIC FIELD SENSING ELEMENTS AND A TIME-DERIVED SENSOR OUTPUT PROTOCOL**

(30) Priority: 30.01.2024 US 202418426449
(71) Applicant: Allegro MicroSystems, LLC, Manchester, NH 03103 (US)
(72) Inventor: Veilleux, Shaun, Manchester (US)
(74) Representative: South, Nicholas Geoffrey

(57) **Abstract**

According to one aspect of the disclosure, a sensor for detecting speed of a target includes: one or more of magnetic field sensing elements operable to generate one or more magnetic field signals indicative of a magnetic field associated with the target having a speed; detection circuitry configured to detect one or more parameters of the target using the magnetic field signals or representations thereof; and an output circuit configured to generate a sensor output signal conveying information about the one or more parameters of the target at a fixed time interval independent of the target speed.

## Description

### FIELD

This disclosure relates generally to sensors and more particularly, to output signal protocols for magnetic field sensors having multiple processing channels.

### BACKGROUND

Sensors are used to monitor various parameters of a system. For example, in vehicle systems, parameters such as current, speed, angle, linear position, and rotational direction of an article associated with a control unit, such as a power steering module, a fuel injection module, and an anti-lock brake module, are often monitored. The sensor output signal is provided to a system controller, such as an Electronic Control Unit (ECU), that processes the sensor output signal and may generate a feedback signal for desired operation of the control unit.

### SUMMARY

Speed sensors can provide an output signal representative of a speed of a target object (e.g., angular velocity/frequency of a wheel) and possibly other parameters of the target, such as direction of rotation. A speed sensor may provide an output signal according to a particular output protocol/format, such as a variable pulse width (PW) protocol or the AK protocol.

A variable PW output protocol may be implemented in sensors which need to communicate both speed and direction of the target. When a target (e.g., a gear having magnetic or ferromagnetic teeth) rotates in front of the sensor, the sensor generates output pulses based on the topology of the target (e.g., a fixed number of pulses per tooth-valley period). The speed data is provided by the output pulse rate which can be calculated from the time between consecutive rising edges (period) of the output signal. The direction data may be indicated by the duration of the output pulses (pulse width).

The AK output protocol may be used with applications requiring additional target parameters beyond just speed and direction. The AK protocol comprises a series of AK messages, e.g., a fixed number of messages per tooth-valley period of rotating target. Each AK message (or "word") includes a high-current speed pulse followed by a sequence of mid-current data pulses. The data pulses are Manchester encoded and can be used to indicate parameters/data such as target direction, validity of target direction, target air gap indication, etc.

Conventional speed sensors provide an output signal that includes one message (e.g., a variable width pulse or an AK message) per each fixed amount of rotation. In other words, the output signal has a rate that depends on the target's speed. The faster the target moves, the more messages there are in a unit time, which can result in loss of resolution at higher speeds and impose a maximum sensing speed. Thus, data output by conventional speed sensors may be referred to as speed-derived sensor output data or, more succinctly, speed-derived data.

Described herein are circuits, systems, and techniques for providing a time-derived sensor output protocol, meaning an output signal protocol that conveys data about one or more parameters of a target at a fixed time interval independent of the target frequency. In some embodiments, a sensor output signal can be generated wherein each message provides data about how one or more target parameters (e.g., amount of target rotation) have changed since a prior message. Because the messages occur at a fixed time interval independent of target speed, disclosed circuits, systems, and techniques may be described as providing a time-derived sensor output protocol. Data conveyed using said protocol may be described as time-derived sensor output data or, more succinctly, time-derived data.

Compared to conventional sensor circuits, systems, and techniques, disclosed embodiments allow for increased sensing speeds without saturating the output communication channel, increased data throughput (e.g., in terms of the number of sensed target parameters), and reduced hardware requirements at the control unit for interpreting the formatted sensor output data.

According to one aspect of the disclosure, a sensor for detecting speed of a target includes: one or more of magnetic field sensing elements operable to generate one or more magnetic field signals indicative of a magnetic field associated with the target having a speed; detection circuitry configured to detect one or more parameters of the target using the magnetic field signals or representations thereof; and an output circuit configured to generate a sensor output signal conveying information about the one or more parameters of the target at a fixed time interval independent of the target speed.

In some embodiments, the one or more parameters of the target include angle of rotation of the target. In some embodiments, the angle of rotation of the target conveyed at a second time is a difference in angle of rotation of target between a first time to the second time, the first and second times separated by the fixed time interval. In some embodiments, the output signal also conveys information associated with the sensor. In some embodiments, the information associated with the sensor includes a temperature associated with the sensor. In some embodiments, the information associated with the sensor includes diagnostics associated with the sensor.

In some embodiments, the output signal conveys the information about the one or more parameters of the target using a Single-Edge Nibble Transmission (SENT) protocol. In some embodiments, the output signal conveys the information about the one or more parameters of the target using words comprising a speed pulse followed by a sequence of data pulses. In some embodiments, the data pulses are Manchester encoded. In some embodiments, the speed pulses have a first current and the data pulses have a second current different from the first current.

In some embodiments, the sensor includes a programmable memory to store the fixed time interval. In some embodiments, the output circuit is configured to recieve a signal for adjusting the fixed time interval. In some embodiments, the sensor provides a terminal configured to provide the output signal and to receive the signal for adjusting the fixed time interval.

In some embodiments, the one or more of magnetic field sensing elements include one or more Hall elements. In some embodiments, the one or more of magnetic field sensing elements include one or more magnetoresistance (MR) elements.

In some embodiments, the detection circuitry and the output circuit are provided as digital circuitry, wherein the sensor includes an analog-to-digital converter (ADC) to convert the magnetic field signals to digital magnetic field signals, wherein the detection circuitry is configured to detect the one or more parameters of the target using the digital magnetic field signals.

According to another aspect of the disclosure, a method for detecting speed of a target includes: receiving, by a sensor, one or more magnetic field signals indicative of a magnetic field associated with the target having a speed; detecting, by the sensor, one or more parameters of the target using the magnetic field signals or representations thereof; and generating, by the sensor, an output signal conveying information about the one or more parameters of the target at a fixed time interval independent of the target speed.

It should be appreciated that individual elements of different embodiments described herein may be combined to form other embodiments not specifically set forth above. Various elements, which are described in the context of a single embodiment, may also be provided separately or in any suitable sub-combination. It should also be appreciated that other embodiments not specifically described herein are also within the scope of the following claims.

### BRIEF DESCRIPTION OF THE DRAWINGS

The manner of making and using the disclosed subject matter may be appreciated by reference to the detailed description in connection with the drawings, in which like reference numerals identify like elements.
Fig. 1 is a block diagram of a system in which a time-derived sensor output protocol may be used, according to embodiments of the disclosure.
Fig. 2 is a schematic diagram of a sensor using a time-derived sensor output protocol, according to some embodiments.
Fig. 3 is a graphical diagram showing an example of a Single-Edge Nibble Transmission (SENT) protocol that may be used by a sensor, according to some embodiments.
Figs. 4A and 4B are graphical diagrams showing examples of a time-derived output signal protocol that may be used within a sensor, according to some embodiments.
Fig. 5 is a flow diagram showing a process for generating a time-derived output signal protocol, according to some embodiments.

The drawings are not necessarily to scale, or inclusive of all elements of a system, emphasis instead generally being placed upon illustrating the concepts, structures, and techniques sought to be protected herein.

### DETAILED DESCRIPTION

As used herein, the term "magnetic field sensing element" is used to describe a variety of electronic elements that can sense a magnetic field. The magnetic field sensing element can be, but is not limited to, a Hall effect element, a magnetoresistance element, or a magnetotransistor. As is known, there are different types of Hall effect elements, for example, a planar Hall element, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, for example, a spin valve, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb).

As is known, some of the above-described magnetic field sensing elements tend to have an axis of maximum sensitivity parallel to a substrate that supports the magnetic field sensing element, and others of the above-described magnetic field sensing elements tend to have an axis of maximum sensitivity perpendicular to a substrate that supports the magnetic field sensing element. In particular, planar Hall elements tend to have axes of sensitivity perpendicular to a substrate, while metal based or metallic magnetoresistance elements (e.g., GMR, TMR, AMR) and vertical Hall elements tend to have axes of sensitivity parallel to a substrate.

As used herein, the term "magnetic field sensor" is used to describe a circuit that uses one or more magnetic field sensing elements, generally in combination with other circuits. A magnetic field sensor can be, for example, a speed sensor, a current sensor, or a proximity detector.

Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector (or movement detector) that senses passing ferromagnetic articles, for example, magnetic domains of a ring magnet or a ferromagnetic target (e.g., gear teeth) where the magnetic field sensor is used in combination with a back-bias or other magnet, and a magnetic field sensor that senses a magnetic field density of a magnetic field.

Signals with pulses are described herein as generated by a magnetic field sensor. In some embodiments, the signals are provided on a communication link to an external processor, for example, a CPU within an automobile, to further process the pulses.

Ferromagnetic objects described herein can have a variety of forms, including, but not limited to, a ring magnet having one or more pole pair, and a gear having two or more gear teeth. Ferromagnetic gears are used in some examples below to show a rotating ferromagnetic object having ferromagnetic features, i.e., teeth. However, in other embodiments, the gear can be replaced with a ring magnet having at least one pole pair. Also, linear arrangements of ferromagnetic objects are possible that move linearly.

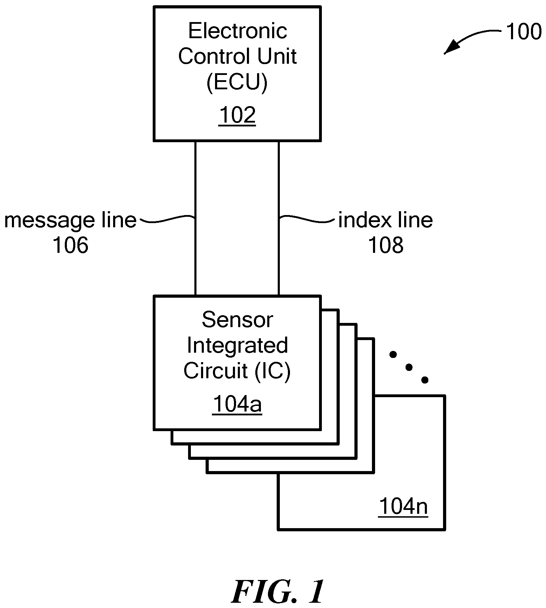

Referring to Fig. 1, a system 100 includes an electronic control unit (ECU) 102 and one or more sensors 104a-n (104 generally). As shown, sensors 104 may be provided as integrated circuits (ICs). Sensors 104 can include sensors of various types, such as, for example, a current sensor, a speed sensor, an angle sensor, a magnetic field sensor, a temperature sensor, a pressure sensor, a chemical sensor, a motion sensor, a rotational direction sensor, a position sensor, an optical sensor, and so forth. Sensors 104 may be the same type of sensor (e.g., each a magnetic field sensor) or may be different types of sensors (e.g., one is a temperature sensor, and the others are magnetic field sensors). Sensors 104 may monitor the same or different parameters of a target object (not shown).

A given one of the sensors 104 can include one or more sensing elements configured to sense one or more parameters associated with a target. Sensing elements may take various forms depending on the sensor type and application. For example, the sensing elements can include, but are not limited to magnetic field sensing elements, optical detectors, temperature sensors. The target can also take various forms. For example, in the case of a magnetic field sensor, a sensed target can take the form of a ring magnet or a ferromagnetic target (e.g., gear teeth) where the magnetic field sensor is used in combination with a back-biased magnet. The sensed parameter(s) can include target position (e.g., angular position), target speed (e.g., angular velocity), and/or target direction (e.g., direction of rotation), to name a few examples. Features of the disclosure are described herein in connection with sensor 104 taking the form of a speed sensor, however the general concepts and techniques sought to be protected may be applicable to other types of sensors.

A given one of the sensors 104 may further include a processor coupled to the sensing element(s) and configured to generate a sensed signal indicative of the parameter(s) associated with the target. In the case of a magnetic field sensor for example, the sensed signal can be the output signal of a magnetic field transducer such as a Hall effect or magnetoresistance element. The sensor can further include an output module coupled to receive the sensed signal and configured to output data indicative of the sensed parameter(s) using a time-derived output protocol, examples of which are described in detail below.

The sensor can provide time-derived data to ECU 102 via one or more lines 106, 108 (i.e., signal paths). In some cases, the sensor can output time-derived data on a first line 106 ("message line") and can output other information, such as conventional speed-derived data on a second line 108 ("index line"). Either of the lines 106, 108 may be dedicated for sending time-derived data. Alternatively, a given one of the lines 106, 108 may be used as a shared line to send time-derived data along with other data. In some cases, both lines 106, 108 may be used to send time-derived data, for redundancy. In some cases, time-derived data may be transmitted on a power connection of a sensor IC.

Within the time-derived output signal, messages can occur at a fixed time interval, *t_{fixed}*, and each message can indicate the change in target rotation, Δ*θ*, sensed within that amount of time. The sensor can utilize a clock signal (e.g., a signal generated by an internal clock or received from an external clock) to output messages at the fixed time interval. In more detail, the sensor can use a clock signal to determine when *t_{fixed}* units of time have elapsed since a prior message was output. The fixed time interval, *t_{fixed}*, may be a setting of the sensor stored in memory, for example. In some cases, the sensor may have a default value for *t_{fixed}*, and this default value can be overridden/adjusted by ECU 102 or another external means. That is, *t_{fixed}* may be a predetermined value or a determined value. The sensor can measure, calculate, or otherwise determine the change in target rotation, Δ*θ* using the sensed signal. For example, in the case of a rotating target with a plurality of magnetic or ferromagnetic features, the sensor can count the number of ferromagnetic features (e.g., gear teeth) sensed within a fixed time interval, *t_{fixed}*, using, for example, a peak-to-peak detection technique.

In some cases, one or more of the sensors 104 may be configured to receive a feedback signal from the ECU 102 and adjust its operation based thereon. For example, using a feedback signal, ECU 102 may adjust the fixed time interval, *t_{fixed}*, used by the sensor's time-derived output protocol. A feedback signal may be sent over first line 106 and/or second line 108 (e.g., in the case of a bidirectional protocol), or may be sent over a separate control line (not shown).

ECU 120 can calculate the target speed using the time-derived sensor data as *ω* = Δ*θ* /*t_{fixed}*. In some cases, ECU 120 can calculate the speed using an average of Δ*θ* taken over multiple fixed time intervals, *t_{fixed}.* In some cases, ECU 120 may calculate the target speed using the actual time elapsed between messages output by a sensor, *t_{actual}*, instead of using the fixed time interval, as follows: *ω* = Δ*θ* /*t_{actual}*. This decouples the speed calculation from the sensor's clock (or clock signal) and thus may improve the accuracy of speed calculation and/or be used to normalize time-derived sensor data received from multiple sensors 104.

The format of the time-derived sensor data can be various unidirectional and/or bidirectional formats, such as Single-Edge Nibble Transmission (SENT) or Manchester format. For example, a unidirectional SENT format may be used by a given one of the sensors 104 to transmit absolute data to the ECU 102 on first line 106. In other examples, a bidirectional format (e.g., a triggered SENT or Manchester format) may be used by the sensor to transmit data to the ECU 102 on the first line 106 after receiving a request from the ECU 102.

It will be appreciated that while certain features are described herein with respect to a single one of the sensors 104, the described features can be readily extended for use by multiple sensors and/or multiple ECUs. For example, in some embodiments, a plurality of sensors 104a-n can share a message line 106 and can have separate index lines 108 coupled to a single ECU 102. In some embodiments, the index and message lines associated with a plurality of sensors 104a-n can be coupled together and to a single ECU 102 (e.g., a line may be shared to multiple sensors). Communication on shared index and/or message lines can be sequential (e.g., sensors can take turns transmitting on the shared lines). In some embodiments, one or more sensors may provide data to two or more ECUs.

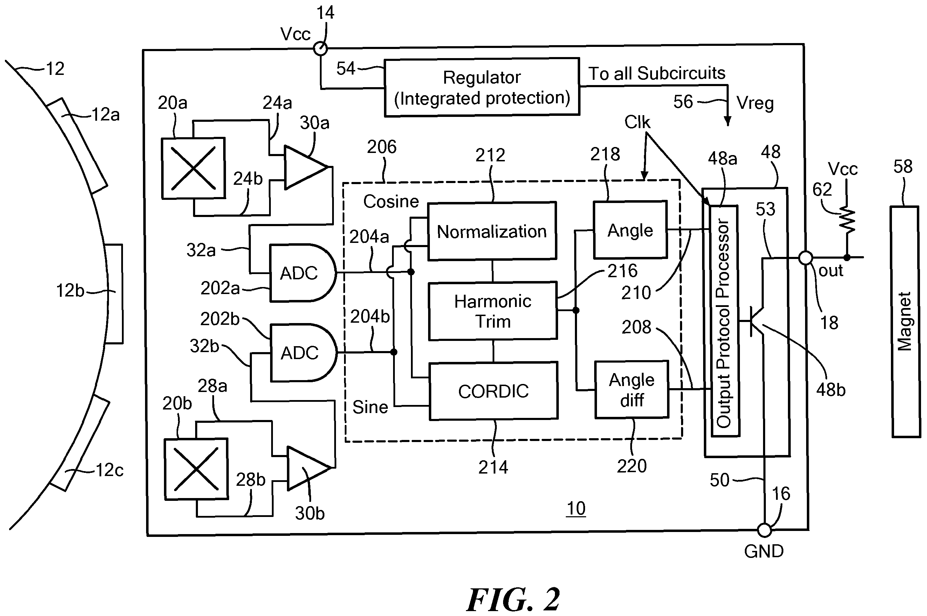

In some cases, one or more of the sensors 104 may be the same as or similar to the sensor described below in conjunction with Fig. 2.

Referring to Fig. 2, an exemplary magnetic field sensor 10 as may take the form of a rotation detector that can be used, for example, to detect passing gear teeth 12a-c of a ferromagnetic gear or, more generally, a target 12. A permanent magnet 58 can be placed at a variety of positions proximate to the target 12, resulting in fluctuations of a magnetic field proximate to the target as it rotates. Use of the above-described magnet 58 results in a so-called "back-bias" arrangement.

Sensor 10 can have a first terminal 14 coupled to a power supply, Vcc, and a second terminal 16 coupled to a fixed voltage, for example, a ground voltage, GND. A third terminal 18 of sensor 10 permits communication of a sensor output signal 52 to circuits and systems external to the sensor, such as an ECU. Sensor output signal 52 can be provided in the form of a voltage signal (as shown in Fig. 2) or a current signal. The illustrated sensor 10 can be considered a three-terminal device (i.e., a three-wire device) since it has third terminal 18 at which output signal 52 is provided. The general techniques disclosed herein can be implemented within two-wire devices, three-wire devices, and devices having other numbers of wires. In some embodiments, sensor 10 can be provided in the form of an integrated circuit (IC), with terminals 14, 16, 18 provided by pins or leads of the IC.

Sensor 10 can include a plurality of magnetic field sensing elements, here shown as having two sensing elements 20a, 20b provide as Hall effect elements. Other types of sensing elements may be used. A first sensing element 20a generates a first differential voltage signal 24a, 24b (corresponding to a first magnetic field signal 24), and a second sensing element 20b generates a second differential voltage signal 28a, 28b (corresponding to a second magnetic field signal 26), each having respective AC signal components in response to the rotating target 12.

While sensing elements 20a, 20b are shown to be two-terminal devices, in practice they may be provided as four terminal devices with the other two terminals coupled to receive and pass respective currents as might be provided, for example, by a current or voltage source.

First magnetic field signal 24 can be received by a first differential amplifier 30a and second differential voltage signal 26 can be received by a second differential amplifier 30b. First and second amplifiers 30a, 30b may generate first and second amplified signals 32a, 32b, respectively. The two amplified signals 32a, 32b can be analog signals, generally sinusoidal in nature.

First and second amplified signals 32a, 32b are received first and second analog-to-digital converters (ADCs) 202a, 202b configure to generate respective first and second digital signals 204a, 204b. The first and second digital signals 204a, 204b, which may be described as cosine and sine signals respectively, are provided as input to detection circuitry 206. Detection circuitry 206 may be implemented using digital signal processing (DSP), for example. The first and second digital signals 204a, 204b may correspond to digital representations of first and second magnetic field signals 24, 26, respectively. For example, first and second digital signals 204a and 204b may have generally sinusoidal waveforms.

Sensor 10 can be considered to two have processing channels, particularly a first channel comprising elements 20a, 30a, 202a and a second channel comprising elements 20b, 30b, 202b. In some cases, the two channels may provide signals 204a, 204b that are in quadrature (i.e., 90° out-of-phase). In some cases, the two channels may provide signals that are less than, or more than, 90° out-of-phase and sensor 10 can calculate quadrature signals therefrom. Herein, "channel" refers generally to processing circuitry associated with one or more magnetic field sensing elements and configured to generate a respective channel signal. Although Fig. 2 shows an example of a two-channel sensor, the general concepts and techniques sought to be protected herein may be applied to sensors with other numbers of channels. Moreover, the circuit elements comprising a given channel may differ from that shown in Fig. 2.

Detection circuitry 206 is configured to process the first and second digital signals 204a, 204b to provide an output signal 208 indicating an amount of target rotation within a fixed time interval, *t_{fixed}.* That is, output signal 208 may encode or otherwise indicate Δ*θ*. Detection circuitry 206 can utilize a clock signal, CLK, to measure Δ*θ* over the fixed time interval, *t_{fixed}.* As illustrated in Fig. 2, detection circuitry 206 may also output another signal 210 indicating an absolute angle, *θ_{abs}*, of target 12.

Detection circuitry 206 can implement various digital processing to calculate Δ*θ* and *θ_{abs}.* For example, in the example shown, detection circuitry 206 can provide normalization processor 212, a coordinate rotation digital computer (CORDIC) 214, a harmonic trim processor 216, an absolute angle processor 218, and an angle change (or difference) processor 220. Normalization processor can track the peaks of each channel and then normalize the two channels so they have the same amplitude. The normalized signals are fed into CORDIC 214, which may require that both signals have the same amplitude and be in quadrature. CORDIC 214 can calculate the angle of the magnetic field from the normalized signals. Harmonic trim processor 216 can further linearize the angle calculation of the CORIC 214. Absolute angle processor 218 can calculate the change in angle from one sample to the next, allowing for the calculation of direction of rotation and speed to be calculated for use in the sensor and or reported (e.g., based on customer/user requirements).

The sensor 10 can include an output protocol module 48 (or "output circuit") coupled to receive and process DSP output 208 and configured to generate output signal 53 that conveys Δ*θ* using a time-derived sensor output protocol as disclosed herein. Output protocol module 48 may utilize the clock signal, CLK, to generate messages at the fixed time interval, *t_{fixed}*, with each message conveying Δ*θ* and possibly other information such as diagnostics, temperature, etc. In some cases, absolute angle output 210 (*θ_{abs}*) can be conveyed as output (i.e., reported) in addition to, or in place of, Δ*θ*. Temperature may be measured using a temperature sensor (not shown) onboard sensor 10, for example. Diagnostics can be determined by on-chip diagnostics circuitry to make the sensor ASIL rated. If there is a failure on-chip the sensor will report this failure alerting the user (e.g., customer) that the sensor data may not be trustworthy and may need to be replaced. This is done to increase safety as if the sensor is providing incorrect data the user will be alerted.

In the illustrated wire sensor 10, output protocol module 48 can include an output protocol processor 48a and an output driver 48b, as may take the form of an open-drain output as shown. In this configuration, the driver 48b may include a bipolar transistor having a drain terminal coupled to Vcc through a pull up resistor 62, as shown. In some examples, output protocol processor 48a may be implemented using DSP.

In some cases, the fixed time interval, *t_{fixed}*, can be adjusted in response to an external signal. For example, sensor 10 may support a bi-directional protocol such as PSI5, which allows data transfer using the VCC line, or the SENT protocol, which allows bi-directional communication over the data line (e.g., using terminal 18 in Fig. 2).

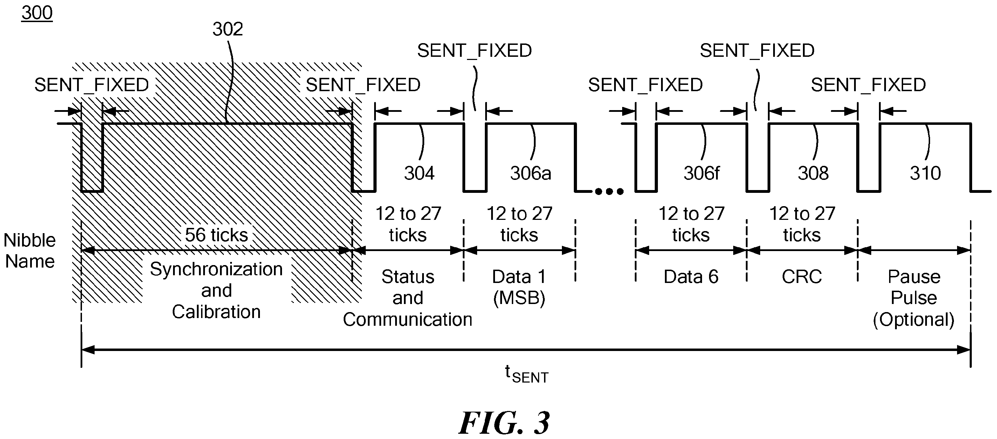

Fig. 3 shows an example of a Single-Edge Nibble Transmission (SENT) protocol 300 that may be used by a sensor (e.g., one of the sensors 104 of Fig. 1 and/or sensor 10 of Fig. 2), according to some embodiments. As shown, a message can include a synchronization and calibration pulse 302, a status and communication pulse 304, a plurality of data pulses 306a...306f (306 generally), a cyclic redundancy check (CRC) pulse 308, and an optional pause pulse 310.

The data pulses 306 can be used to convey one or more parameters of a target (e.g., a ferromagnetic gear) including but not limited to change in target rotation (which in turn can be used to calculate the target speed). Each data pulse 306 may convey four bits of data, or a nibble. In the example of Fig. 3, each SENT message can convey six (6) nibbles using six data pulses 306a...306f. The data pulses can convey change in target rotation, Δ*θ*, measured within a fixed time interval, *t_{fixed}*, along with additional information. Table 1 shows one possible use of the six (6) nibbles. As shown, multiple nibbles can be used to communicate change in target rotation, Δ*θ*, as well as temperature. Of note, Δ*θ* may be communicated as a signed number to indicate both direction and angle of rotation.

**Table 1**

| Nibble | Information |
|---|---|
| 1 | Delta Rotation (Δ*θ*) [11:8] |
| 2 | Delta Rotation (Δ*θ*) [7:4] |
| 3 | Delta rotation [3:0] |
| 4 | Diagnostics [3:0] |
| 5 | Temperature [7:4] |
| 6 | Temperature [3:0] |

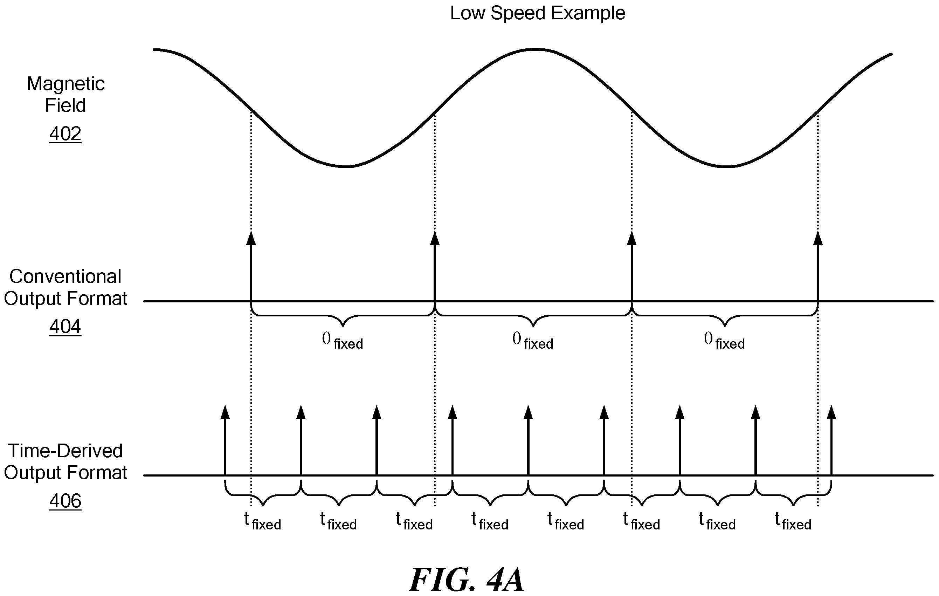

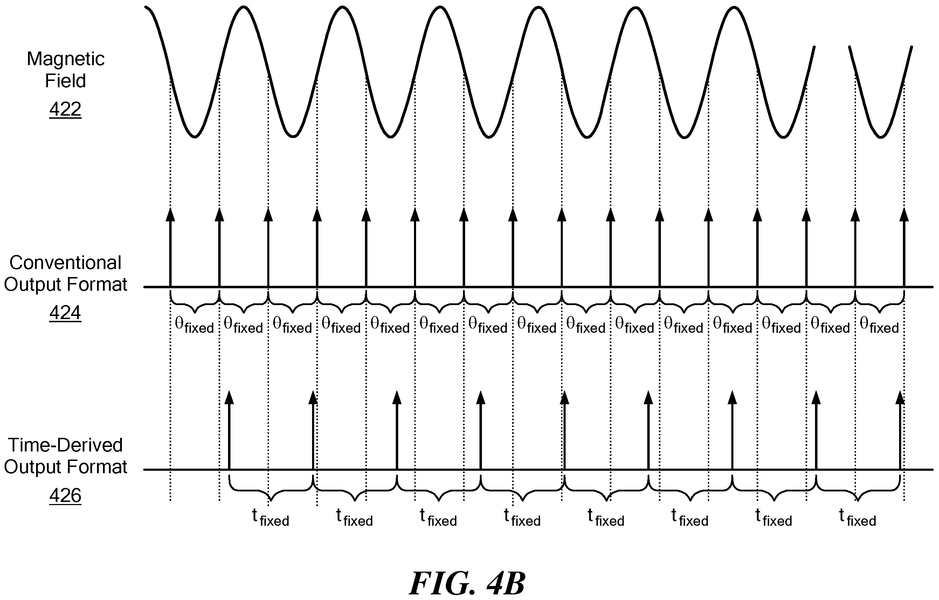

Figs. 4A and 4B show examples of a time-derived output signal protocol that may be used within a sensor (e.g., one of the sensors 104 of Fig. 1 and/or sensor 10 of Fig. 2), according to some embodiments. In more detail, these figures compare a conventional output format with messages occurring per fixed amount or rotation, *θ_{fixed}*, to time-derived output format with messages occurring at a fixed time interval, *t_{fixed}.*

As illustrated in Fig. 4A, a magnetic field signal 402 can be generated in response to a target moving at a relatively low speed. A conventional output format 404 communicates messages (illustrated as vertical arrows) for every *θ_{fixed}* amount of target rotation. In contrast, a time-derived output format 406 communicates messages every *t_{fixed}* units of time.

Turning to Fig. 4B, a magnetic field signal 422 can be generated in response to a target moving at a relatively fast speed (e.g., faster than illustrated in Fig. 4A). In this case, messages according to a time-derived output format 426 appear to be spaced further part, as the message spacing is independent of the target speed. In contrast, messages according to a conventional output format 424 are spaced according to the frequency of the sinusoidal magnetic field signal 422. Thus, with a conventional sensor output format, the faster the target moves, the more messages there are in a unit time, which can result in loss of resolution at higher speeds and impose a maximum sensing speed. These problems are eliminated using a time-derived output format according to the present disclosure.

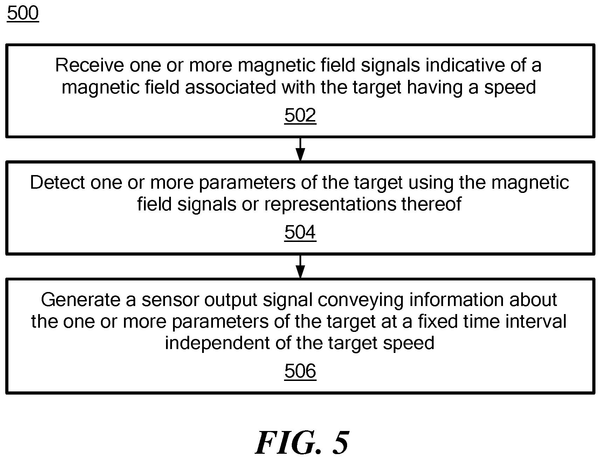

Fig. 5 shows an illustrative process 500 for generating a time-derived output signal protocol, according to some embodiments. Process 500 can be implemented and/or performed by a speed sensor, such as one of the sensors 104 of Fig. 1 and/or sensor 10 of Fig. 2. At block 502, one or more magnetic field signals can be received indicative of a magnetic field associated with the target having a speed (e.g., a rotating gear having ferromagnetic teeth or other features). At block 504, one or more parameters of the target can be detected using the magnetic field signals or representations thereof. At block 506, a sensor output signal can be generated, the signal conveying information about the one or more parameters of the target at a fixed time interval independent of the target speed.

As used herein, the terms "processor" and "controller" are used to describe electronic circuitry that performs a function, an operation, or a sequence of operations. The function, operation, or sequence of operations can be hard coded into the electronic circuit or soft coded by way of instructions held in a memory device. The function, operation, or sequence of operations can be performed using digital values or using analog signals. In some embodiments, the processor or controller can be embodied in an application specific integrated circuit (ASIC), which can be an analog ASIC or a digital ASIC, in a microprocessor with associated program memory, in a digital signal processor (DSP), and/or in a discrete electronic circuit, which can be analog or digital. A processor or controller can include internal processors or modules that perform portions of the function, operation, or sequence of operations. Similarly, a module can include internal processors or internal modules that perform portions of the function, operation, or sequence of operations of the module. A single processor or other unit may fulfill the functions of several means recited in the claims.

As used in the claims or elsewhere herein, the term "comprising" does not exclude other elements or steps, and the indefinite article "a" or "an" does not exclude a plurality.

As used herein, the term "predetermined," when referring to a value or signal, is used to refer to a value or signal that is set, or fixed, in the factory at the time of manufacture, or by external means, e.g., programming, thereafter. As used herein, the term "determined," when referring to a value or signal, is used to refer to a value or signal that is identified by a circuit during operation, after manufacture.

While electronic circuits shown in figures herein may be shown in the form of analog blocks or digital blocks, it will be understood that the analog blocks can be replaced by digital blocks that perform the same or similar functions and the digital blocks can be replaced by analog blocks that perform the same or similar functions. Analog-to-digital or digital-to-analog conversions may not be explicitly shown in the figures but should be understood.

In the foregoing detailed description, various features are grouped together in one or more individual embodiments for the purpose of streamlining the disclosure. This method of disclosure is not to be interpreted as reflecting an intention that each claim requires more features than are expressly recited therein. Rather, inventive aspects may lie in less than all features of each disclosed embodiment.

References in the disclosure to "one embodiment," "an embodiment," "some embodiments," or variants of such phrases indicate that the embodiment(s) described can include a particular feature, structure, or characteristic, but every embodiment can include the particular feature, structure, or characteristic. Moreover, such phrases are not necessarily referring to the same embodiment(s). Further, when a particular feature, structure, or characteristic is described in connection knowledge of one skilled in the art to affect such feature, structure, or characteristic in connection with other embodiments whether or not explicitly described.

The disclosed subject matter is not limited in its application to the details of construction and to the arrangements of the components set forth in the detailed description or illustrated in the drawings. The disclosed subject matter is capable of other embodiments and of being practiced and carried out in various ways. As such, those skilled in the art will appreciate that the conception, upon which this disclosure is based, may readily be utilized as a basis for the designing of other structures, methods, and systems for carrying out the several purposes of the disclosed subject matter. Therefore, the claims should be regarded as including such equivalent constructions insofar as they do not depart from the spirit and scope of the disclosed subject matter.

Although the disclosed subject matter has been described and illustrated in the foregoing exemplary embodiments, it is understood that the present disclosure has been made only by way of example, and that numerous changes in the details of implementation of the disclosed subject matter may be made without departing from the spirit and scope of the disclosed subject matter.

Other variations to the disclosed embodiments can be understood and effected by those skilled in the art in practicing the claimed invention, from a study of the drawings, the disclosure, and the appended claims.

The mere fact that certain measures are recited in mutually different dependent claims does not indicate that a combination of these measures cannot be used to obtain an advantage.

Any reference signs in the claims should not be construed as limiting the scope.

All publications and references cited herein are expressly incorporated herein by reference in their entirety.

## Claims

1. A sensor for detecting speed of a target, comprising:
one or more of magnetic field sensing elements operable to generate one or more magnetic field signals indicative of a magnetic field associated with the target having a speed;
detection circuitry configured to detect one or more parameters of the target using the magnetic field signals or representations thereof; and
an output circuit configured to generate a sensor output signal conveying information about the one or more parameters of the target at a fixed time interval independent of the target speed.

2. The sensor of claim 1 wherein the output signal also conveys information associated with the sensor.

3. The sensor of claim 1 wherein the output signal conveys the information about the one or more parameters of the target using words comprising a speed pulse followed by a sequence of data pulses.

4. The sensor of claim 1 comprising a programmable memory to store the fixed time interval.

5. The sensor of claim 1 wherein the output circuit is configured to recieve a signal for adjusting the fixed time interval.

6. The sensor of claim 5 comprising a terminal configured to provide the output signal and to receive the signal for adjusting the fixed time interval.

7. The sensor of claim 1 wherein the one or more of magnetic field sensing elements comprise one or more Hall elements.

8. The sensor of claim 1 wherein the one or more of magnetic field sensing elements comprise one or more magnetoresistance (MR) elements.

9. The sensor of claim 1 wherein the detection circuitry and the output circuit are provided as digital circuitry, wherein the sensor comprises an analog-to-digital converter (ADC) to convert the magnetic field signals to digital magnetic field signals, wherein the detection circuitry is configured to detect the one or more parameters of the target using the digital magnetic field signals.

10. A method for detecting speed of a target, comprising:
receiving, by a sensor, one or more magnetic field signals indicative of a magnetic field associated with the target having a speed;
detecting, by the sensor, one or more parameters of the target using the magnetic field signals or representations thereof; and
generating, by the sensor, an output signal conveying information about the one or more parameters of the target at a fixed time interval independent of the target speed.

11. The method of claim 10, or the sensor of claim 1, wherein the one or more parameters of the target include angle of rotation of the target.

12. The method of claim 10, or the sensor of claim 1, wherein the one or more parameters of the target include angle of rotation of the target and the angle of rotation of the target conveyed at a second time is a difference in angle of rotation of target between a first time to the second time, the first and second times separated by the fixed time interval.

13. The method of claim 10 wherein the output signal also conveys information associated with the sensor.

14. The method of claim 13, or the sensor of claim 2, wherein the information associated with the sensor includes a temperature associated with the sensor.

15. The method of claim 13, or the sensor of claim 2, wherein the information associated with the sensor includes diagnostics associated with the sensor.

16. The method of claim 10, or the sensor of claim 1, wherein the output signal conveys the information about the one or more parameters of the target using a Single-Edge Nibble Transmission (SENT) protocol.

17. The method of claim 10 wherein the output signal conveys the information about the one or more parameters of the target using words comprising a speed pulse followed by a sequence of data pulses.

18. The method of claim 17, or the sensor of claim 3, wherein the data pulses are Manchester encoded.

19. The method of claim 17, or the sensor of claim 3, wherein the speed pulses have a first current and the data pulses have a second current different from the first current.
